Europäisches Patentamt

European Patent Office

Office européen des brevets

(11) Publication number: **0 306 565**
**A1**

(12) # EUROPEAN PATENT APPLICATION

(21) Application number: **87201742.1**

(22) Date of filing: **11.09.87**

(51) Int. Cl.⁴: **G03F 5/00 , G03F 3/10 , G03F 3/06**

(43) Date of publication of application:
**15.03.89 Bulletin 89/11**

(84) Designated Contracting States:
**AT BE CH DE ES FR GB GR IT LI LU NL SE**

(71) Applicant: **AGFA-GEVAERT naamloze vennootschap**
**Septestraat 27**
**B-2510 Mortsel(BE)**

(72) Inventor: **Vinck, Paul Walter**
**Singel 22**
**B-2510 Mortsel(BE)**

(54) **Process for dot-size correction of halftone images.**

(57) Method for the correction or modification of halftone separation images used in the preparation of multicolour prints, which method comprises the production and use of dot size increase masks that contain areas of different optical density to provide correction in dot size in one common (single) exposure step for all the areas to be corrected in a separation image.

FIG. 2

EP 0 306 565 A1

## PROCESS FOR DOT-SIZE CORRECTION OF HALFTONE IMAGES

The present invention relates to dot-size correction or modification in halftone images, and more particularly concerns the use of said correction in a process for producing colour-corrected or colour-modified colour separation records for used in the production of printing plates for printing reproductions of coloured originals, in particular of colour photographs or art-work.

In photomechanical colour printing, inks of the subtractive colours cyan, magenta and yellow are used, as well as a certain amount of black applied by the black printer. Because of the overlapping spectral absorption bands of the subtractively coloured inks, the use of printing plates produced from photographic colour separation halftones without any correction usually results in poor quality colour reproduction. Colour reproduction normally involves corrections for hue, saturation and lightness values. Apart from colour corrections necessary for faithful colour reproduction, colour modifications are often necessary for special effects, for example for purely aesthetic reasons or in order to achieve a heightened visual impact of selected matter in printed advertisements.

The correction of halftone images is therefore particularly important with regard to the correction of black-and-white colour separation prints serving as photomasks in the production of printing plates for printing with subtractive colour printing inks.

It is known to effect colour corrections or modifications by making over-exposed photographic contact prints of one or more of the initial halftone separations. The amount and distribution pattern of any one of the printing inks in a multicolour print depends on the dot size distribution in the corresponding printing plate, which distribution in turn depends on the dot size distribution in the halftone separation directly used in the making of the plate. By producing a first or a second generation contact-print of the initial halftone separation using an appropriately controlled exposure dose in area to be dot-size corrected a print wherein the dots in said area are smaller or larger than those of the initial separation can be produced, which print can then be directly used in making the corresponding printing plate. This technique for colour-correction or modification wherein dot-sizes are changed photographically and specifically in the areas where modification is required by controlled over-exposure is known in the art as "dry dot etching" or "dry etching" (see e.g. Research Disclosure July 1983, item 23135).

When it is necessary to apply the dry etching technique for effecting a colour change in (a) selected area(s) of an image, as determined for example from an examination of a colour proof, one or more isolation masks is or are made for use in combination with one or more of the initial halftone separations when making the aforesaid contact prints. An isolation mask protects the light-sensitive print material from the excess exposure dose except in the area where the dot size change is required. The over-exposure results in an increase of dot size. If colour change is required in an area of simple shape, a suitable mask can be produced from a so-called cut-and-peel film or by hand-lacquering a mask film (see e.g. DE-P 3 140 955). For more complicated shapes it is much better to produce the mask photographically. By comparing a colour area to be corrected with a colour atlas or colour chart it is possible to determine what combination of halftone positives and/or negative halftone prints of the original when contact printed, as a sandwich, onto a photographic silver halide emulsion film with a particular light dose, will produce a print having negligible optical density in the area where the colour correction is required. Such a photographic method of mask production is described in Research Disclosure July 1983, item 23135. Since it is necessary to produce a transparent mask area free from any dot structure a diffuse exposure of said sandwich is applied, e.g. by using in contact exposure a transparent interlay film between the selected halftone separations and the film wherein the mask has to be produced.

It is not uncommon for colour corrections or modifications to be required in several distinct areas identified by examination of a colour proof and for a corresponding number of different masks to be required for use in making the colour-corrected or modified separations. The known procedure for preparing the corrected or modified halftone separations is rather laborious even when using a relatively small number of isolation masks. In order to make a contact print having the required altered dot sizes from any given initial halftone separation a photographic print material has to be exposed to the initial separation in register with each of the masks in turn, as well as to the initial separation in unmasked state. The larger the number of in-register manipulations of the masks and initial halftone colour separations which are required the greater is the risk for misregistration errors such as dot-doubling. Another feature of the known procedure which has to be borne in mind is the necessity to ensure that the exposure dose in each of the masked exposures is adjusted to achieve the dot size change required in the unmasked area.

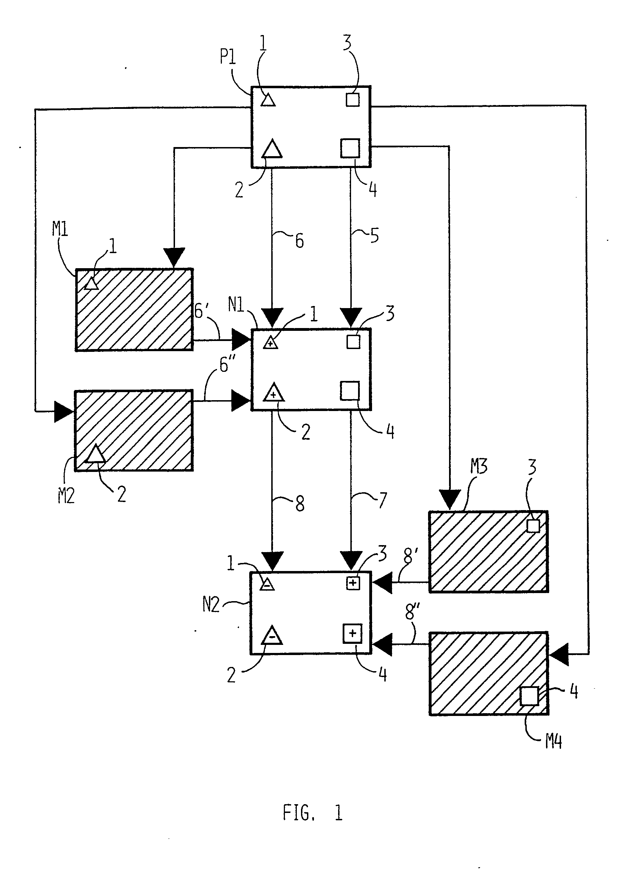

A simple example of the preparation of a colour-corrected or modified colour separation according to the above described prior art procedure is schematically illustrated in Fig. 1 of the accompanying drawings. Referring to this figure: P1 represents a positive halftone separation as produced by exposure of light-sensitive film to red, blue or green light transmitted through or from the artwork or other original to be printed, via a red, blue or green filter. Alternatively the halftone separations are produced on a laser scanner recorder by a procedure known to those skilled in the art.

From examination of a colour proof printed by using printing plates produced by means of the different halftone separations, of which P1 is one, four areas have been identified in which colour modification is required. The corresponding areas of P1 have been identified by triangles 1 and 2 and by squares 3 and 4. The triangles 1 and 2 represent areas in which the required modification necessitates a decrease in the dot size. Squares 3 and 4 represent areas in which the dot size has to be increased. The percentage dot size decrease required in area 1 differs from that required in area 2. Likewise the percentage dot size increase required in area 3 is different from that required in area 4. The percentage change in dot size which is required in each area in order to effect the required colour change in that area is determined from optical density measurements in that area of the initial halftone separations and by reference to charts, or in the case of computer assisted processing it can be determined by an appropriately programmed data processor fed with the relevant data.

Colour proofing processes which can be used in identifying areas in which colour changes should be effected are described e.g. in GB-P 1,264,313 and 1,340,046.

Preparatory to producing from the halftone separation P1 a contact print exhibiting the required dot size changes in the areas corresponding with areas 1, 2, 3 and 4, four isolation masks M1, M2, M3 and M4 are prepared, in each of which an area corresponding with one of the areas 1-4 is of negligible optical density whereas the remaining area is substantially opaque to the printing light to be used in making the colour-modified contact print.

In a contact exposure step represented by arrow 5 a negative working silver halide emulsion film N1 is exposed through the halftone separation P1. In further distinct contact exposure steps represented by arrows 6-6′ and 6-6″ respectively, the film N1 is subjected to contact exposure through P1 and mask M1 and through P1 and mask M2 respectively. Because N1 is a negative working film the additional exposure doses in the areas 1 and 2 as defined by the masks M1 and M2 have the effect of increasing the sizes of the dots in the those areas of the latent image in the film. In each of the exposure steps 6-6′ and 6-6″ the exposure dose is controlled so that it results in the required predetermined percentage dot size change in the area 1 or 2 as the case may be, of the negative film.

After development of the exposed film N1 it is used in a contact exposure step represented by arrow 7 for forming a corresponding positive latent image in a second negative working silver halide emulsion film N2 so that the dots of this positive image exhibit the required decrease in dot sizes in the areas 1 and 2. In further distinct contact exposure steps represented by arrow 8-8′ and 8-8″ respectively, the film N2 is subjected to contact exposure through N1 and mask M3 and through N1 and M4 respectively.The additional exposure doses in the areas 3 and 4 as defined by the masks M3 and M4 has the effect of increasing the sizes of the dots in those areas of the latent image in the film. In each of those exposures through the masks the exposure dose is controlled so that it results in the required predetermined percentage dot size change in the area 3 or 4 as the case may be. After development of the film N2 it is ready for use as a colour-modified halftone separation in the preparation of a printing plate.

In the event that only the dot size reductions, in areas 1 and 2, were required, it would not be necessary to produce two successive contact prints. The colour-modified halftone separation could be made by directly exposing a positive-working silver halide emulsion film to the initial halftone separation P1 without a mask and also to such separation masked by each of the masks M1 and M2 in turn.

The foregoing example is of a very simple kind for illustrative purposes. In practice a larger number of masks and a correspondingly greater number of contact exposure steps is required for producing any one colour-corrected or modified halftone separation.

It is an object of the present invention to provide a process whereby a halftone colour separation for use in the production of a printing plate can be produced wherein different dot-size corrections in a plurality of areas for colour correction or modification can proceed in fewer steps and with less risks of misregistration errors.

According to the present invention there is provided a process for producing halftone images being corrected or modified in dot-size in certain areas, and suited for use in making a printing plate for printing reproductions of an image from an initial photographic halftone colour separation which in a plurality of areas has dot sizes which are either smaller or larger than those which the printing plate should have in those areas for achieving a required colouring effect; which process comprises the steps of determining the percentage dot size increase or decrease required in each of said areas, and exposing and processing light-sensitive material (called print material) thereby to produce by mask controlled over-exposure a print exhibiting the required dot size changes in said areas; characterized in that (1) said light-sensitive print material is exposed through an assembly of said initial separation and a masking means comprising a photographic film element having in its areas coinciding with the said areas of the initial separation in which dot size decrease or increase is required, optical densities such that the required dot size changes in said areas can be produced in said print material (while no dot size change occurs in the remaining areas requiring no dot size correction or modification) by means of a common (single) exposure dose emitted while said film element is in its masking position in said assembly; and in that (2) in said exposure of said print material the said common exposure dose is emitted while said film element is in its masking position thereby to bring about desired dot size changes in said areas requiring dot size correction or modification.

According to possible embodiments of said common exposure in said masking position either said photographic film element is interposed between said initial separation and said print material or said initial separation is interposed between photographic film element and said print material.

The invention enables through the use of single-element exposure masks combined with a common exposure dose to obtain colour-corrected or modified halftone colour separations with fewer copying exposure steps than are necessary according to the prior art practice. The reduction in the number of steps, each of which requires registration of materials in a printing frame, can be considerable, depending on the number of different areas of a halftone separation image in which correction or modification is required. It is not uncommon for corrections or modifications to be required in eight or more different areas.

If the corrections or modifications required in respect of a given halftone colour separation are such as to necessitate dot size decreases in certain areas and dot size increases in other areas, these different kinds of alteration can be effected by using the processed print material, having the required dot size reductions or enlargements, for producing a second generation print of reversed image values (i.e. in negative-to-positive or positive-to-negative relationship to the first print) and using a masked over-exposure step, i.e. over-exposure through a single mask, in the production of the second generation print for effecting the dot size increases or decreases as the case may be. In such an embodiment of the present invention it is preferable to use a single-element photographic mask as above specified in the production of the second generation print as well as in the production of the first generation print.

Another important advantage of the invention is that it is neither necessary to alter the over-exposure dosage to effect different percentage dot size increases or decreases as the case may be in different areas nor to have an initial or final non-masked exposure step.

According to an embodiment of the present invention said masking means, called hereinafter correction mask, is produced by the steps :

(1) one initial non-masked (overall) exposure of a positive-working silver halide emulsion film,

(2) successive exposures of different exposure dose of the thus exposed film through isolation masks containing each an area of negligible optical density in a non-light transmittive background, each said area corresponding with an area to be corrected or modified in dot size, and

(3) developing said film obtaining thereby a different optical density in each of said areas, the highest optical density being obtained in the background area but that is to some degree still transmittive to light.

For obtaining a dot size increase said masking means assembled with the initial separation is used in said common exposure in combination with a negative working silver halide emulsion print material, which on development provides a halftone separation containing areas having increased dot size with respect to said initial halftone separation.

For obtaining a dot size decrease said halftone separation containing areas having increased dot size is copied for image reversal on another negative working silver halide emulsion print material to obtain therewith a halftone separation containing areas having decreased dot size with respect to said initial halftone separation.

The photographic material used for the production of said correction masks is preferably a material suited for continuous tone reproduction having a large exposure latitude, i.e. fairly soft gradation.

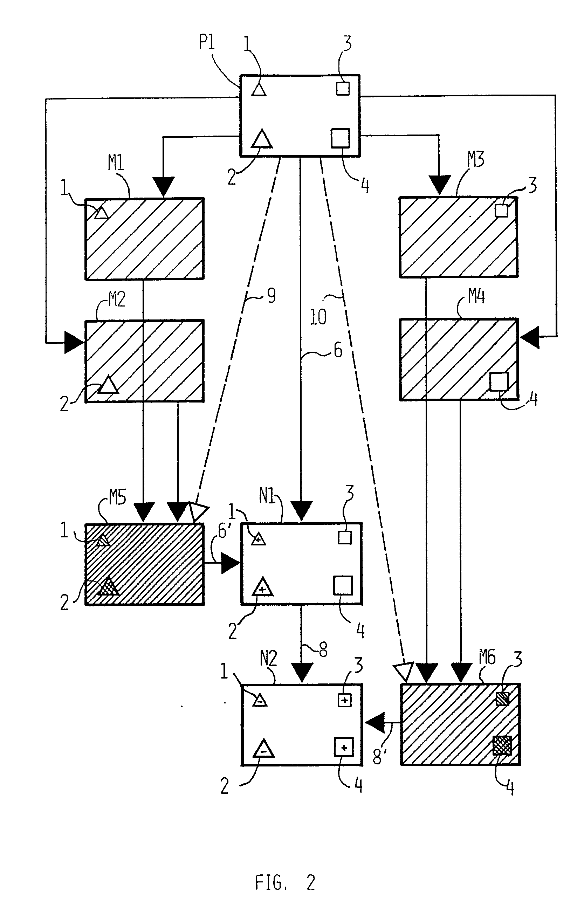

A simple example of a process according to the invention, selected for easy comparison with Fig. 1, is schematically represented in Fig. 2 of the accompanying drawings. In this figure, elements which are substantially identical with elements represented in Fig. 1 are denoted by the same reference indicia as in that figure.

Thus in Fig. 2 P1 is a halftone separation image corresponding with P1 in Fig. 1; the triangles 1,2 denote areas in which a dot size reduction is required and the squares 3,4 denote areas in which a dot size increase is required.

Isolation masks M1, M2, M3 and M4 are prepared, each of which, like the correspondingly denoted mask in Fig. 1, has an area of negligible optical density corresponding with one of the areas 1-4 but is otherwise effectively opaque. However, in the process according to the invention, the masks M1-M4 are used for a different purpose. Instead of being interposed one by one between the initial halftone separation P1 and film N1 or film N2 as the case may be preparatory to an over-exposure step, the masks are used for producing composite photographic correction masks M5 and M6. The mask M5 is a dot size increase mask prepared by successively exposing a light-sensitive positive-working film to masks M1 and M2 after an initial non-masked (overall) exposure has been given and developing the latent images so that the areas 1, 2 and the background areas thereof have different predetermined optical densities. The background density obtained by said overall exposure is the highest density, whereas the densities in the areas corresponding with the areas to be dot size corrected have an appropriate lower value to obtain the desired degree of overexposure for dot size increase. In other words, the density in each of those areas (areas 1 and 2) is such that the common exposure dose emitted during the later masked printing step will be so modulated by said areas of the mask that the over-exposure dose reaching the film N1 will bring about the required percentage dot size increase in each of said areas. In the remaining background area, which corresponds with the area of the initial halftone separation in which no correction or modification is required, the mask M5 has a density such that it produces no correction or modification of the initial halftone separation when used in the masked printing step. The mask M6 is a dot size increase mask prepared in a similar manner, from masks M3 and M4. The optical densities of areas 3 an 4 of mask M6 are such that the light doses reaching areas 3 and 4 of the film N2 during the masked exposure of that film will effect the required dot size increases in those areas. While the density of the remaining areas is such that it produces no correction or modification of the initial halftone separation in these areas.

The negative-working film N1 is exposed in a single step while the mask M5 is in position between the separation P1 and the film N1. This single exposure step is represented by arrows 6 and 6'. After development of the film N1 it is contact printed in a single exposure step as represented by arrows 8 and 8' onto negative-working film N2 while the mask M6 is in position between the two films N1 and N2.

It is to be noted that each of the films N1 and N2 is subjected to only one masked exposure and that even if there were several more areas in which dot size decreases or increases were required it would still suffice to use a single dot size decrease mask and a single dot size increase mask and to use each such mask in a single masked exposure of the film N1 or N2 as the case may be. If there are more areas requiring a dot size decrease or increase than can reasonably be corrected by a single mask then of course an extra dot size decrease mask or an extra dot size increase mask as the case may be can be prepared for correcting the extra areas.

As in a process as described with reference to Fig. 1, if only dot size decreases were required, the halftone separation P1 could be printed in masked state directly onto a positive-working film, instead of using the combination of the two negative working films N1 and N2.

The masks M1-M4 can be prepared photographically. The mask areas 1-4 should be free from any dot pattern and in exposing photographic film for producing any of the masks, a transparent interlay film can be used between the mask film and the halftone separation and a matt layer on top of the halftone separation to achieve a diffuse exposure.

As an alternative to the use of a photographic technique the masks M1-M4 can be produced by a plotting and cutting method.

It is of course not necessary to prepare all of the said masks by one and the same method.

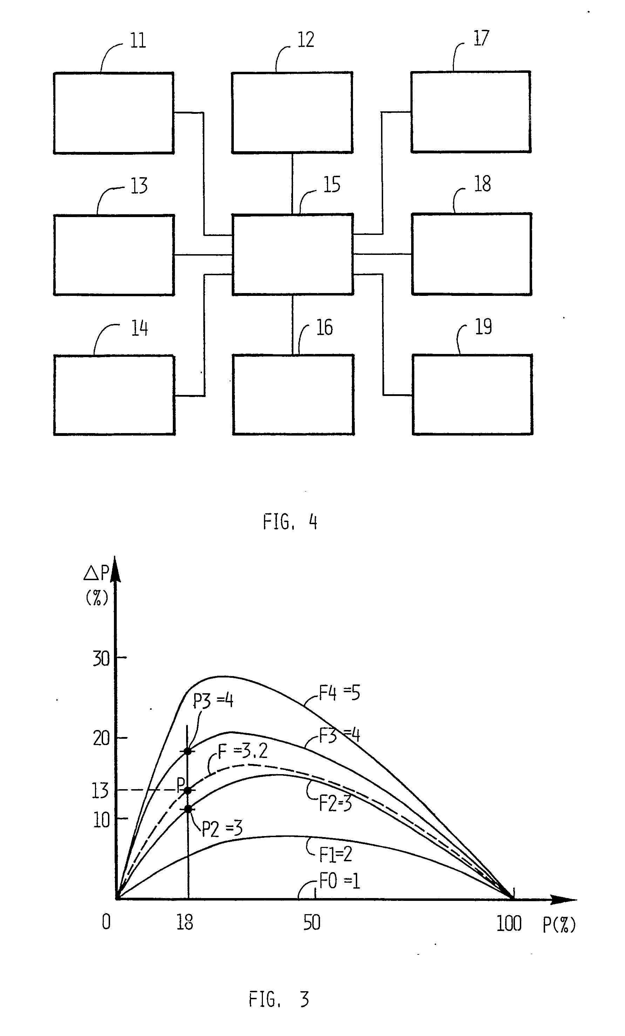

The broken lines 9 and 10 in Fig. 4 represent an alternative way of carrying out the present invention which dispenses with the need for the masks M1-M4. In this alternative procedure, each of the photographic masks M5 and M6 is produced with the aid of a digital isolation mask stored as a digital data file in a computer (not shown). Each file of digital data is used to control the exposure of a light-sensitive element by means of a writing laser scanner and that element is then developed to form the photographic mask M5 or M6.

In the embodiment operating with a contact exposure of any photographic mask for use in carrying out the present invention it is advantageous to use so-called room-light film which can be handled in normal room light without fogging but is still sensitive enough for exposure in a contact-exposure camera with the usual light-sources. Examples of such films are described in Research Disclosure, March 1978, item 16,735 and in US-P. 2,219,667. Due to the absence of spectral sensitization those materials can be handled in bright yellow light without fogging.

According to an other embodiment the photographic masks are produced on a laser recorder scanner using films that have the appropriate spectral sensitivity for the applied laser beam.

In order to determine the appropriate optical densities for the mask areas through which the overexposure doses are transmitted for effecting the dot size changes it is necessary to assess, for each area, the overexposure dose which will bring about the dot size change required in that area. For this purpose use can be made of empirically determined gauge-curves which indicate the dot size-increasing effect of various relative exposure factors on dots of various initial sizes when using light-sensitive material of the category which is to be used in the process.

Fig. 3 of the accompanying drawings is an example of a set of such gauge-curves which are drawn by plotting dot size increases $\Delta P$ (%) against initial dot size P (%). The different curves F0-F4 relate to different over-exposure doses, expressed as relative log Exposure factors F.

If for example the dot size in a given area of an initial halftone separation is 18 on the abscissa scale of the graph and it is required to increase the dot size in that area by an increment 13 on the ordinate scale, then the over-exposure dose or relative exposure factor required for that purpose in unmasked state can be represented by a point P. By analogy from the empirically established adjacent curves F2-F3 passing through points P2 and P3, an exposure factor curve F can then be drawn through point P to represent the effect of that exposure factor on dots of various initial sizes. In the given example the dashed line in Figure 3 corresponds with an interpolated exposure factor value 3.2. If no dot size change is required the halftone separation should be used with an exposure corresponding with exposure factor F0 = 1.

For any given print film area exposed through a photographic mask the exposure factor is related to the log radiant energy density required for effecting the requisite dot size change, in accordance with the following equation :

$$\log W = \log [ E.t (1 + K.F) ] - D$$

wherein :

W is the radiant energy density (J/m2) to be applied to obtain the desired dot size change,

E is the radiant excitance of the exposure device light source (W/m²),

t is the exposure time (s),

K is a constant characteristic for the applied exposure light source,

F is the exposure factor,

D is the mask density in the given area.

E, t and K are exposure device related constants.

The value W is calculated for different dot size changes by inserting in the above equation the actually applied system parameters, which for the example are fictionally chosen to be :

$E = 1.5\times10^{-3}$ W/m2, K = 1.5, t = 10 s and the density D being the mask density is set to be equal to zero. Operating with these parameters in the above equation for each exposure factor a corresponding W value can be calculated, which for an exposure factor F = 3.2 is $87\times10^{-3}$ J/m2, and for F0 = 1 is equal to $37.5\times10^{-3}$ J/m2.

When carrying out the present invention, in order to determine an appropriate exposure factor F for performing an exposure through a single mask of a print material in combination with an initial halftone separation, account is taken of the highest radiant energy density ($W_{max}$) required for achieving the highest dot size change in a particular area to be exposed through the mask and the minimum mask density that can be obtained with the mask film used.

The exposure factor is re-calculated using an actual minimum density (fog density = $D_{min}$) for the developed film material solving the above equation for F. In the present example when $D_{min}$ = 0.2 the exposure factor F becomes at least 5.46 for a $W_{max}$ of $87\times10^{-3}$ J/m2.

It is then possible to determine the different optical densities which are required in the mask areas through which over-exposure will take place in order that the different dot size changes required in the corresponding areas of the print material will be brought about by the simultaneous over-exposure of those areas through the mask, applying the single predetermined exposure factor.

Each mask density can be found with the above equation solved for D, viz. D = log[E.t(1 + K.F)] - log W. In the present example the mask densities will be D = 0.2 and D = 0.56 for the areas requiring maximum dot size change and no dot size change respectively.

By contrast, in prior art practice, it was necessary to determine an exposure factor for each of the different areas requiring different dot size changes and the exposure factor for the initial or final non-masked exposure for the areas requiring no dot size change. (see the aforementioned Research Disclosure July 1983, item 23135).

Various operations involved in the performance of the process according to the invention can be carried out or assisted by automatic means.

Instead of relying on visual assessment of colour proofs for identification of required corrections, a densitometer can be used for measuring the integral density of representative spots in any given area of the halftone separations and density readings can be translated into percent dot values.

The process can be partly or almost entirely automated using a micro-processor or computer.

The information pertaining to appropriate over-exposure doses as represented by the gauge curves of Fig. 3, or by a nomograph, can be written in the form of a software program and fed to a computer which determines from that data and other input data the appropriate over-exposure dose for particular applications of the process, expressed as an exposure factor calibrated with respect to the exposure apparatus and the light-sensitive material to be used.

The exposure apparatus itself can incorporate a micro-processor chip which serves for direct exposure control in an electronic processing based on a software program as above referred to.

As an example of a kind of relatively unsophisticated apparatus which can be used when carrying out the invention, the apparatus may comprise a densitometer, an operator console comprising a graphic video monitor screen provided with a mouse driven monitor cursor, a computer linked to a high capacity storage device and a computer controlled contact frame exposure device.

For realising improved and more versatile area isolation the apparatus can also comprise a digitizer tablet and a graphic mask plotter or mask cutter device. An apparatus including a said digitizer tablet and graphic mask plotter or mask cutting device can operate in conjunction with a scanning-reading device and a writing laser exposure device.

Fig. 4 of the accompanying drawings is a block diagram of an example of an apparatus assembly designed for use in carrying a process according to the invention.

The apparatus assembly contains the following operative parts:

- a densitometer 11 under the light detection head of which the halftone separation can be moved manually for measuring the densities of elementary surface areas, called elementary spots, which densities identify the % dot values of such spots;

- an operator console 12 comprising a graphic video monitor provided with a mouse driven monitor cursor, allowing the computer assisted creation and display of correction masks;

- a digitizer 13 which provides digital values for the spatial definition of area contours obtained as relative point coordinates in appropriate elementary distance units,

- a reading scan device 14 which allows the scanning of a separation image on a point by point or line by line base and generates signals representing the densities or % dot values of elementary spots;

- a computer 15 with interfacing circuits to the peripheral devices 11, 12, 13, 14, 16, 17, 18 and 19.

- a high capacity digital storage means 16,

- a computer controlled contact frame exposure device 17,

- a computer controlled graphic plotter or cutter device 18,

- a computer controlled scanning exposure device 19, e.g. a writing laser scanner.

As an example of a rather basic apparatus assembly which is useful in performing a process according to the invention, the apparatus may comprise a densitometer 11, an operator console 12, a computer 15, a digital storage means 16 and a computer controlled contact frame exposure device 17.

When carrying out the invention with the assistance of a computer, the process can for example proceed as follows: The operator starts by entering the mode of operation defining the peripherals that will be used to carry out the halftone correction. The areas to be corrected and the amount of correction needed are specified. The areas to be corrected are defined by their densities, corresponding with particular % dot values, or by contour coordinates of the initial separation. A mouse driven monitor cursor can be used whereby the contours of the areas on which correction is required are displayed on a monitor screen. The data defining said areas are entered into the computer as digitized readings which may be derived from a density reading device, a digitizer tablet or a scan device. The corrections required are determined and entered by keyboard or by mouse driven menu into the computer as a desired dot size change in the defined areas.

Separate area isolation masks, when required, can be produced by a photographic technique or plotting and cutting technique (or a combination of said techniques for the different area isolation masks), and used one by one with an appropriate computer controlled exposure dose for producing one or more photographic correction masks in photographic silver halide emulsion material as hereinbefore described. Alternativel y, digital isolation masks can be used. By digital isolation masks is meant that the data representing the areas to be isolated are stored and processed to form files of digital data which constitute such masks. Such digital masks can directly effect exposure control of a writing laser scanner, the mask data serving to modulate the radiant energy density of the scanning laser beam for exposing a positive or negative working silver halide film which then on development forms a single dot-size increase mask or a single dot-size decrease mask.

The dot size increases and/or decreases which will result from the use of the prepared masks can then be checked for correctness by measuring the densities of some control points in the masks.

Claims

1. A process for producing halftone images being corrected or modified in dot-size in certain areas, and suited for use in making a printing plate for printing reproductions of an image from an initial photographic halftone colour separation which in a plurality of areas has dot sizes which are either smaller or larger than those which the printing plate should have in those areas for achieving a required colouring effect; which process comprises the steps of determining the percentage dot size increase or decrease required in each of said areas, and exposing and processing light-sensitive material (called print material) thereby to produce by mask controlled over-exposure a print exhibiting the required dot size changes in said areas; characterized in that (1) said light-sensitive print material is exposed through an assembly of said initial separation and a masking means comprising a photographic film element having in its areas coinciding with the said areas of the initial separation in which dot size decrease or increase is required, optical densities such that the required dot size changes in said areas can be produced in said print material (while no dot size change occurs in the remaining areas requiring no dot size correction or modification) by means of a common (single) exposure dose emitted while said film element is in its masking position in said assembly; and in that (2) in said exposure of said print material the said common exposure dose is emitted while said film element is in its masking position thereby to bring about desired dot size changes in said areas requiring dot size correction or modification.

2. A process according to claim 1, wherein in said masking position while applying said common exposure said photographic film element is interposed between said initial separation and said print material or wherein in said masking position while applying said common exposure said initial separation is interposed between said photographic film element and said print material.

3. A process according to claim 1 or 2, wherein said masking means is produced by the steps :

(1) one initial non-masked (overall) exposure of a positive-working silver halide emulsion film,

(2) successive exposures of different exposure dose of the thus exposed film through isolation masks containing each an area of negligible optical density in a non-light transmittive background, each said area corresponding with an area to be corrected or modified in dot size, and

(3) developing said film obtaining thereby a different optical density in each of said areas, the highest optical density being obtained in the background area but that is to some degree still transmittive to light.

4. A process according to claim 3, wherein said masking means is used in said common exposure in masking position in said assembly using a negative working silver halide emulsion print material, which on development provides a halftone separation containing areas having increased dot size with respect to said initial halftone separation.

5. A process according to claim 4, wherein said halftone separation containing areas having increased dot size is copied for image reversal on another negative working silver halide emulsion print material to obtain therewith a halftone separation containing areas having decreased dot size with respect to said initial halftone separation.

6. A process according to claim 1, wherein said photographic film element is prepared as a mask by exposure thereof under the control of digital masks.

7. A process according to claim 6, wherein areas of the initial separation in which dot size changes are required are defined by their densities expressed in % dot values and these data are digitized and stored in a memory of a computer and used as said digital masks.

8. A process according to claim 6, wherein areas of the initial separation in which dot size changes are required are defined by their contour coordinates on an electronic digitizer tablet and the coordinate data are digitized and stored in a memory of the computer and used as said digital masks.

9. A process according to any preceding claim, wherein the initial separation in which dot size changes are required is displayed on a monitor screen and the areas to be corrected are located by means of a mouse driven monitor cursor.

10. A process according to any preceding claim, wherein the magnitudes of the dot size changes required in a plurality of said areas of the initial separation are entered by keyboard or by mouse driven menu into a computer from which signals are derived which are used to determine the value of said common exposure dose.

11. A process according to any preceding claim, wherein the exposures of said print material are contact exposures.

12. A process according to any preceding claim, wherein the photographic film element is a room-light photographic material.

13. A process according to any preceding claim, performed by means of apparatus assembly comprising a densitometer, an operator console comprising a graphic video monitor screen provided with a mouse driven monitor cursor, a computer linked to a high capacity storage device and a computer controlled contact frame exposure device.

14. A process according to claim 13, wherein the apparatus assembly also comprises a digitizer tablet and a graphic mask plotter or mask cutter device.

15. A process according to claim 13, wherein the apparatus assembly also comprises a digitizer tablet, a scanning-reading device and a writer laser exposure device.

FIG. 1

FIG. 2

FIG. 4

FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | DE-C-3 614 684   (DU PONT)<br>* Claims *<br>----- | 1 | G 03 F   5/00<br>G 03 F   3/10<br>G 03 F   3/06 |

TECHNICAL FIELDS
SEARCHED (Int. Cl.4)

G 03 F   5/00
G 03 F   3/10
G 03 F   3/06

The present search report has been drawn up for all claims

| Place of search | Date of completion of the search | Examiner |
|---|---|---|
| THE HAGUE | 09-05-1988 | RASSCHAERT A. |